# EUROPÄISCHE PATENTANMELDUNG

(11) **EP 3 739 345 A1**
(43) Veröffentlichungstag der Anmeldung: **18.11.2020**
(21) Anmeldenummer: 19174895.3
(22) Anmeldetag: 16.05.2019
(51) Int. Cl.: G01R 15/20

(54) **ERFASSEN EINES IN EINER ELEKTRISCHEN LEITUNG FLIESSENDEN ELEKTRISCHEN STROMS**

(71) Anmelder: Siemens Aktiengesellschaft, 80333 München (DE)
(72) Erfinder: Behringer, Klaus, 91338 Igensdorf (DE); Burger, Josef, 92546 Schmidgaden (DE); Bär, Thomas, 92260 Fichtenhof (DE); Lehmeier, Annemarie, 92289 Ursensollen (DE); Meier, Matthias, 92284 Poppenricht (DE)

(57) **Zusammenfassung**

Die Erfindung betrifft eine Messanordnung (10) zum Erfassen eines in einer elektrischen Leitung (5) fließenden elektrischen Stroms, die Messanordnung (10) umfassend
- die elektrische Leitung (5),
- eine Strommesseinheit (2), die wenigstens zwei Magnetfeldsensoren (1a, 1b, 1c, 1d) zum Erfassen eines durch den elektrischen Strom hervorgerufenen Magnetfelds (6) aufweist, und
- eine Filtereinheit zum Homogenisieren (9) von nicht durch den elektrischen Strom hervorgerufenen Magnetfeldern (7) am Ort der Magnetfeldsensoren (1a, 1b, 1c, 1d).

## Beschreibung

Die Erfindung betrifft eine Messanordnung zum Erfassen eines in einer elektrischen Leitung fließenden elektrischen Stroms. Die Erfindung betrifft außerdem ein Verfahren zum Erfassen eines in einer elektrischen Leitung fließenden elektrischen Stroms.

In technischen Anlagen, Schaltschränken, Einschüben oder Gebäudeautomatisierungen werden Kabel oder Stromschienen zur Energieverteilung verwendet. Steigendes Umweltbewusstsein und wachsende Energiekosten erfordern eine Vermeidung von Energieverschwendung und speziell eine effiziente Nutzung elektrischer Energie. Das hierfür erforderliche Energiemanagement benötigt als Eingangsgröße eine detaillierte Überwachung der Energieverteilung. Hierbei sind insbesondere die Energieflüsse zu den an ein elektrisches Energieversorgungsnetz angeschlossenen Verbrauchern von Interesse. Um ein Energiemanagement betreiben zu können, müssen insbesondere elektrische Ströme erfasst werden, die in elektrischen Leitungen zwischen dem Energieversorgungsnetz und den Verbrauchern fließen.

DE 102010043254 A1 (Siemens AG) 03.05.2012 offenbart ein Messsystem zur Überwachung mindestens einer Phase eines elektrischen Systems, z.B. eines Verbraucherabzweigs, wobei Hallsensoren als Strommessgeräte verwendet werden. Mit einem auf dem Hall-Effekt basierenden Hallsensor lassen sich berührungslos Gleichströme messen: Bei einer solchen Strommessung wird mithilfe des Hallsensors der stromproportionale magnetische Fluss um einen stromdurchflossenen elektrischen Leiter gemessen. Falls der Steuerstrom des in diesem Magnetfeld angeordneten Hallsensors konstant gehalten wird, ist die in dem Hallsensor auftretende Hallspannung U_{H} proportional zur Feldstärke des Magnetfelds und somit proportional zum Leiterstrom.

Der Erfindung liegt die Aufgabe zugrunde, eine verbesserte Messanordnung zum Erfassen eines in einer elektrischen Leitung fließenden elektrischen Stroms bereitzustellen. Der Erfindung liegt außerdem die Aufgabe zugrunde, ein verbessertes Verfahren zum Erfassen eines in einer elektrischen Leitung fließenden elektrischen Stroms bereitzustellen.

Die Aufgabe, eine verbesserte Messanordnung bereitzustellen, wird gelöst durch eine Messanordnung zum Erfassen eines in einer elektrischen Leitung fließenden elektrischen Stroms, die Messanordnung umfassend die elektrische Leitung, eine Strommesseinheit, die wenigstens zwei Magnetfeldsensoren zum Erfassen eines durch den elektrischen Strom hervorgerufenen Magnetfelds aufweist, und eine Filtereinheit zum Homogenisieren von nicht durch den elektrischen Strom hervorgerufenen Magnetfeldern am Ort der Magnetfeldsensoren.

Die Messanordnung dient zum Erfassen eines elektrischen Stroms, welcher durch eine elektrische Leitung fließt. Eine durch die Erfassung gewonnene Zielgröße ist die Stromstärke I des elektrischen Stroms.

Die Messanordnung umfasst die elektrische Leitung, z.B. ein Stromkabel, eine auf einer Leiterplatte, z.B. einem PCB (= Printed Circuit Board), angeordnete Leiterbahn oder eine Stromschiene.

Die Messanordnung umfasst eine Strommesseinheit, die wenigstens zwei Magnetfeldsensoren zum Erfassen eines durch den elektrischen Strom hervorgerufenen Magnetfelds aufweist. Jeder elektrische Strom erzeugt ein ihn umgebendes Magnetfeld: Um eine elektrische Leitung bildet sich bei geschlossenem Stromkreis ein Magnetfeld. Das Magnetfeld wirkt hierbei senkrecht zur stromführenden Leitung selbst. Die Feldlinien ordnen sich kreisförmig um die Leitung an, die den Mittelpunkt des Magnetfeldes bildet.

Als Magnetfeldsensor kann ein beliebiger magnetisch empfindliche Sensor dienen, insbesondere ein Sensor, welcher auf mindestens einem der folgenden Effekte basiert: Hall-Effekt, AMR (= Anisotroper Magneto-Resistiver Effekt), GMR (= Giant Magneto-Resistance).

Die Messanordnung umfasst außerdem eine Filtereinheit zum Homogenisieren von externen Magnetfeldern, d.h. von Magnetfeldern, welche nicht durch den durch die elektrische Leitung fließenden elektrischen Strom hervorgerufen werden, am Ort der Magnetfeldsensoren. Homogene Magnetfelder haben analog zu homogenen elektrischen Feldern die Eigenschaft, dass sie an jedem Ort gleich stark und gleichgerichtet sind. Gibt es zwischen zwei Punkten eines Magnetfelds weder eine Flussänderung noch einen Feldstärkenunterschied und ist es ein gleichbleibendes Feld, dessen Feldlinien allesamt parallel in dieselbe Richtung verlaufen, spricht man von einem homogenen Magnetfeld.

Die Aufgabe, ein verbessertes Verfahren bereitzustellen, wird gelöst durch ein Verfahren zum Erfassen eines in einer elektrischen Leitung fließenden elektrischen Stroms, wobei wenigstens zwei Magnetfeldsensoren im Bereich eines Magnetfelds, welches durch den elektrischen Strom hervorgerufen wird, angeordnet werden; wobei nicht durch den elektrischen Strom hervorgerufene externe Magnetfelder am Ort der Magnetfeldsensoren homogenisiert werden; wobei das durch den elektrischen Strom hervorgerufene Magnetfeld und die diesem überlagerten homogenisierten Magnetfelder mithilfe der Magnetfeldsensoren erfasst werden; und wobei aus den Messsignalen der Magnetfeldsensoren die Stärke des elektrischen Stroms bestimmt wird.

Das Verfahren dient zum Erfassen eines in einer elektrischen Leitung fließenden elektrischen Stroms. Dabei werden wenigstens zwei Magnetfeldsensoren im Bereich eines Magnetfelds, welches durch den elektrischen Strom hervorgerufen wird, angeordnet. Externe Magnetfelder, welche nicht durch den elektrischen Strom hervorgerufen werden, werden so beeinflusst, dass sie am Ort der Magnetfeldsensoren als homogene Magnetfelder vorliegen. Das durch den elektrischen Strom hervorgerufene Magnetfeld und die diesem überlagerten homogenisierten Magnetfelder werden mithilfe der Magnetfeldsensoren erfasst. Schließlich wird aus den Messsignalen der Magnetfeldsensoren die Stärke des elektrischen Stroms bestimmt.

Der Erfindung liegt die Erkenntnis zugrunde, dass es mit wirtschaftlich vertretbarem Aufwand nicht möglich ist, ein oder mehrere externe Magnetfelder vollständig aus der Messanordnung am Ort der Magnetfeldsensoren zu verdrängen. Falls das oder die externen Magnetfelder vollständig aus der Messanordnung am Ort der Magnetfeldsensoren verdrängt werden könnten, dann würde ein einziger Magnetfeldsensor zum Erfassen eines durch den elektrischen Strom hervorgerufenen Magnetfelds ausreichen, da in diesem Fall nur eine unbekannte Variable existierte: das zu messende Magnetfeld, welches durch den durch die elektrische Leitung fließenden elektrischen Strom hervorgerufen wird. Da es aber mit wirtschaftlich vertretbarem Aufwand nicht möglich ist, das oder die externen Magnetfelder vollständig aus der Messanordnung am Ort der Magnetfeldsensoren zu verdrängen, basiert die vorliegende Erfindung darauf, das oder die externen Magnetfelder mittels der Filtereinheit möglichst homogen zu machen. Da das oder die externen Magnetfelder nicht verdrängt, sondern homogenisiert werden, existieren am Ort der Magnetfeldsensor zwei sich überlagernde Magnetfelder: (a) das zu messende Magnetfeld, welches durch den durch die elektrische Leitung fließenden elektrischen Strom hervorgerufen wird, und (b) das oder die externen Magnetfelder, welche als Störfelder wirken. Da somit zwei unbekannte Variable, nämlich zwei Magnetfelder unterschiedlichen Ursprungs, existieren, werden mindestens zwei Magnetfeldsensor benötigt, damit das zu messende Magnetfeld von den externen Magnetfeldern unterschieden und ermittelt werden kann, z.B. mithilfe eines Algorithmus in einer Recheneinheit herausgerechnet werden kann. Durch diesen erfindungsgemäßen Aufbau wird erreicht, dass störende externe inhomogene Magnetfelder, z. B. in Form von Kreisbögen oder andersartig verzerrten Feldern, am Ort der Magnetfeldsensoren homogenisiert werden. Im Gegensatz zum klassischen elektrischen Feld wird das störende externe Magnetfeld nicht von der Messanordnung abgeleitet oder abgeschirmt, sondern in dieser homogenisierten Form durch die Messanordnung geleitet.

Ein inhomogenes externes Magnetfeld liefert an jedem Ort des zu messenden Magnetfelds, d.h. desjenigen Magnetfelds, welches durch den durch die elektrische Leitung fließenden elektrischen Strom hervorgerufen wird, einen unterschiedlichen Beitrag zum resultierenden Magnetfeld, welches sich aus der Überlagerung des externen Magnetfelds und des zu messenden Magnetfelds ergibt. Das zu messende Magnetfeld wird also signifikant verfälscht, ohne dass eine einfache Korrektur der Messwerte möglich wäre. Ein homogenes externes Magnetfeld dagegen liefert an jedem Ort des zu messenden Magnetfelds den gleichen Beitrag zum resultierenden Magnetfeld. Das externe Magnetfeld führt also an jedem Ort des zu messenden Magnetfelds nur zu einem konstanten Offset der Feldstärke des zu messenden Magnetfelds. Somit ist eine einfache Korrektur der Messwerte der Magnetfeldsensoren möglich, einfach indem der konstante Offset, der von dem externen Magnetfeld herrührt, von den Messwerten abgezogen wird.

Durch die erfindungsgemäße Messanordnung wird vermieden, dass bei einer auf einer Magnetfeldmessung basierenden Strommessung störende externe Magnetfelder, d. h. nicht von dem zu messenden Strom hervorgerufenen Magnetfelder, mitgemessen werden und so die Strommessung verfälscht wird. Als störende externe Magnetfelder sind zum Beispiel das Erdmagnetfeld, Magnetfelder von in der Umgebung der elektrischen Leitung angeordneten Permanentmagneten oder Magnetfelder von in der Umgebung der elektrischen Leitung verlaufenden weiteren elektrischen Strömen anzuführen. Die von den elektrischen Feldern bekannten Schirmkonzepte können nicht auf DC-Anwendungen übertragen werden, da bei DC-Anwendungen keine Ableitung nach Erde möglich ist (DC = Direct Current). Diese Probleme treten bei Geräten auf, welche Ströme auf Grund magnetischen Feldern messen.

Die erfindungsgemäße Messanordnung verzichtet auf eine Abschirmung störender externer Magnetfelder mithilfe eines geschlossenen Gehäuses aus Metall, da die Abschirmung viele Probleme mit sich bringt: Bei der Montage von metallischen Abschirmgehäusen kann es sein, dass elektrische Leitungen, Platinen, Leiterplatten oder andere Geräteteile durch das Abschirmgehäuse hindurch geführt werden müssen. Öffnungen schwächen aber die Schirmung und scharfe Kanten führen zu hohen Feldern und können die Filterung bzw. Schirmung aushebeln. Weiterhin können bei geschlossenen Gehäusen Spannungsabstände und ESD-Vorschriften in vielen Fällen nicht eingehalten werden (ESD = Electro-Static Discharge). Die erfindungsgemäße Messanordnung umgeht durch einen Verzicht auf schwer durchführbare und aufwändige konstruktive Lösungen alle diese Probleme.

Vorteilhafte Ausgestaltungen und Weiterbildungen der Erfindung sind in den abhängigen Ansprüchen angegeben. Dabei kann das erfindungsgemäße Verfahren auch entsprechend den abhängigen Vorrichtungsansprüchen weitergebildet sein, und umgekehrt.

Gemäß einer bevorzugten Ausgestaltung der Erfindung weist die Filtereinheit zwei Filterelemente auf, zwischen denen die elektrische Leitung und die Magnetfeldsensoren angeordnet sind. Vorzugsweise sind die Filterelemente flach, d.h. plan. Falls die Filterelemente nicht plan wären, sondern z.B. konvex oder konkav gewölbt, würde das "homogenisierte" Magnetfeld zwischen den beiden Filterelementen nicht mehr völlig homogen sein. Vorzugsweise sind die Filterelemente flächig: Flächige Filterelemente sind konstruktiv am einfachsten und am effektivsten. Aber dabei müssen die Filterelemente nicht als geschlossene Platten ausgebildet sein, sondern es ist zulässig, dass die Filterelemente Gitter oder Löcher, analog zu einem Faraday-Käfig, aufweisen.

Gemäß einer bevorzugten Ausgestaltung der Erfindung weisen die Filterelemente einen ferromagnetischen Werkstoff mit einer Permeabilitätszahl µr > 1 auf. Vorzugsweise weisen die Filterelemente einen ferromagnetischen Werkstoff auf, welcher bei magnetischen Feldstärke H von 1000 A/m eine Permeabilitätszahl µᵣ > 1000 hat. Zum Beispiel bestehen die Filterelemente aus Silizium-Eisen oder aus Elektroblech M 330-50 A oder M 530-50 A gemäß DIN EN 10106:2016-03.

Gemäß einer bevorzugten Ausgestaltung der Erfindung weist zumindest eines der Filterelemente einen Abstand a von der elektrischen Leitung auf und weist die Strommesseinheit wenigstens zwei in einem Abstand b benachbart angeordnete Magnetfeldsensoren auf, wobei der Abstand a größer als oder gleich dem Abstand b ist. Für die Anordnung der Filterelemente gilt prinzipiell: I) Je größer der Abstand der Filterelemente von den Magnetfeldsensoren und/oder der elektrischen Leitung ist, desto weniger wird das Material der Filterelemente von dem Magnetfeld, welches von dem durch die elektrische Leitung fließenden elektrischen Strom hervorgerufen wird, beeinflusst. Wenn der Abstand a groß ist, werden mehr unerwünschte Felder homogenisiert und der unbeeinflusste Anteil des Nutzsignals, d.h. des von dem durch die elektrische Leitung fließenden elektrischen Strom hervorgerufenen Magnetfelds, wird größer. Dabei muss die Lage der Filterelemente nicht symmetrisch zu der Strommesseinheit sein. II) Je größer die seitliche Ausdehnung der Filterelemente ist, desto weniger können störende magnetische Felder "seitlich" in die Messanordnung eindringen. III) Je dicker die Filterelemente sind, desto geringer ist deren magnetische Sättigung. Im Bereich der magnetischen Sättigung nimmt die magnetische Leitfähigkeit stark ab; daher ist magnetische Sättigung bei dieser Anwendung unerwünscht.

Gemäß einer bevorzugten Ausgestaltung der Erfindung ist die Strommesseinheit an einer Leiterplatte angeordnet. Das bietet den Vorteil, dass auch andere elektrische Bauteile und elektronische Bauteile, z.B. Kommunikationsbauteile zur Herstellung einer Kommunikationsschnittstelle für eine Übertragung von Messergebnissen, z. B. zur Übertragung in eine Cloud, einfach integriert werden können. Das bietet außerdem den Vorteil, dass eine kompakte und modulare Bauweise der Messanordnung erleichtert wird, wodurch Kosten und Bauraum eingespart werden können.

Gemäß einer bevorzugten Ausgestaltung der Erfindung ist die elektrische Leitung an einer Leiterplatte angeordnet. Das bietet den Vorteil, dass eine kompakte und modulare Bauweise der Messanordnung erleichtert wird, wodurch Kosten und Bauraum eingespart werden können.

Gemäß einer bevorzugten Ausgestaltung der Erfindung umfasst die Strommesseinheit eine Recheneinheit, z.B. einen Prozessor, welche aus den Magnetfeld-Signalen der Magnetfeldsensoren den in der elektrischen Leitung fließenden elektrischen Strom berechnet. Vorzugsweise sind die Recheneinheit und die Strommesseinheit und/oder die elektrische Leitung an derselben Leiterplatte angeordnet. Im Falle, dass die Magnetfeldsensoren als Hall-Sensoren ausgebildet sind, liegen die Magnetfeld-Signale als Hallspannung U_{H} vor. Das homogenisierte externe Magnetfeld liefert an jedem Ort des zu messenden Magnetfelds die gleiche Hallspannung, d.h. einen konstanten Offset der Hallspannungen, die das zu messende Magnetfeld hervorruft. Somit ist eine einfache Korrektur der von den Magnetfeldsensoren gemessenen Hallspannungen möglich, einfach indem die konstante Hallspannung, die von dem homogenisierten externen Magnetfeld herrührt, von den Hallspannungen, die von den Magnetfeldsensoren als Überlagerung des zu messenden Magnetfelds und des homogenisierten externe Magnetfelds gemessen werden, abgezogen wird. Dies ist einfach möglich, falls die Magnetfeldsensoren in Bezug auf das zu messende Magnetfeld so symmetrisch angeordnet werden, dass die Hallspannung sowohl positive als auch negative Werte annimmt.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- Fig. 1: eine herkömmliche Strommesseinheit bei Fehlen eines störenden externen Magnetfelds;
- Fig. 2: eine herkömmliche Strommesseinheit bei Anwesenheit eines störenden externen Magnetfelds;
- Fig. 3: eine erfindungsgemäße Messanordnung bei Fehlen eines störenden externen Magnetfelds;
- Fig. 4: eine erfindungsgemäße Messanordnung bei Anwesenheit eines störenden externen Magnetfelds;
- Fig. 5: Verläufe von Permeabilitätszahlen für als plattenförmige Filterelemente geeignete beispielhafte ferromagnetische Werkstoffe;
- Fig. 6: eine weitere Ausführung einer erfindungsgemäßen Messanordnung;
- Fig. 7: ein zu messendes Magnetfeld, welches durch eine stromdurchflossene Leitung hervorgerufen wird;
- Fig. 8: ein externes inhomogenes Magnetfeld; und
- Fig. 9: ein durch eine Filtereinheit externes homogenisiertes Magnetfeld.

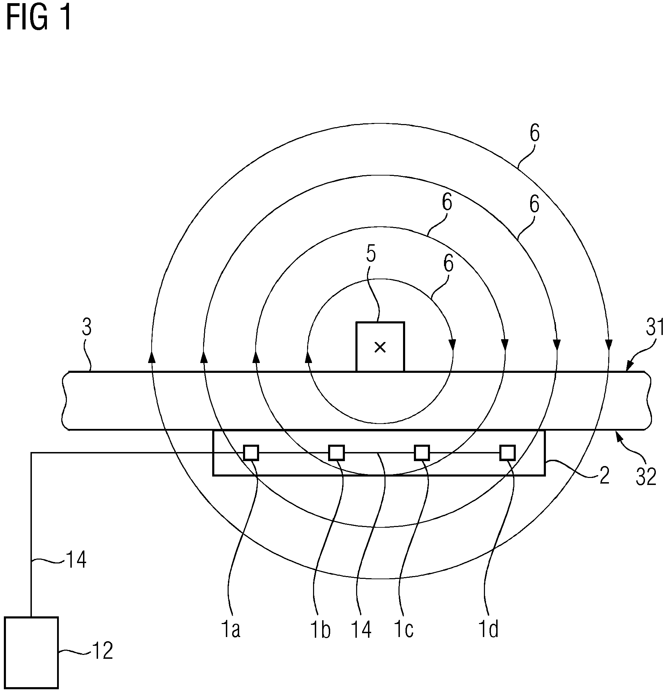

Fig. 1 zeigt einen Schnitt durch eine auf einer ersten Oberfläche 31 einer Leiterplatte 3 angeordnete geradlinige elektrische Leitung 5 in Form einer Stromschiene quadratischen Querschnitts, entlang deren Längsachse, hervorgerufen durch eine an der elektrischen Leitung 5 anliegende Spannungsdifferenz, ein elektrischer Strom fließt. Die technische Stromrichtung, d. h. vom elektrischen Plus- zum Minuspol, ist dabei in die Zeichnungsebene hinein, so dass der Drehsinn der Feldlinien 6 des durch den Stromfluss erzeugten Magnetfelds gemäß der Korkenzieherregel im Uhrzeigersinn ist.

Auf einer zweiten Oberfläche 32 der Leiterplatte 3, die in Bezug auf die Leiterplatte 3 entgegengesetzt zu der ersten Oberfläche 31 liegt, ist ein Strommessmodul 2 angeordnet, welches vier in einer Reihe quer zur elektrischen Leitung 5 angeordnete Hallsensoren 1a bis 1d als Magnetfeldsensoren aufweist. Diese Hallsensoren 1a bis 1d erfassen die in dem Hallsensor auftretende Hallspannung U_{H}, welche proportional zur Feldstärke des Magnetfelds und somit proportional zum Leiterstrom ist, und senden die Spannungswerte über eine Signalleitung 14 zu einer Recheneinheit 12, wo aus den gesammelten Spannungswerten die Stärke des in der elektrischen Leitung 5 fließenden elektrischen Stroms berechnet wird.

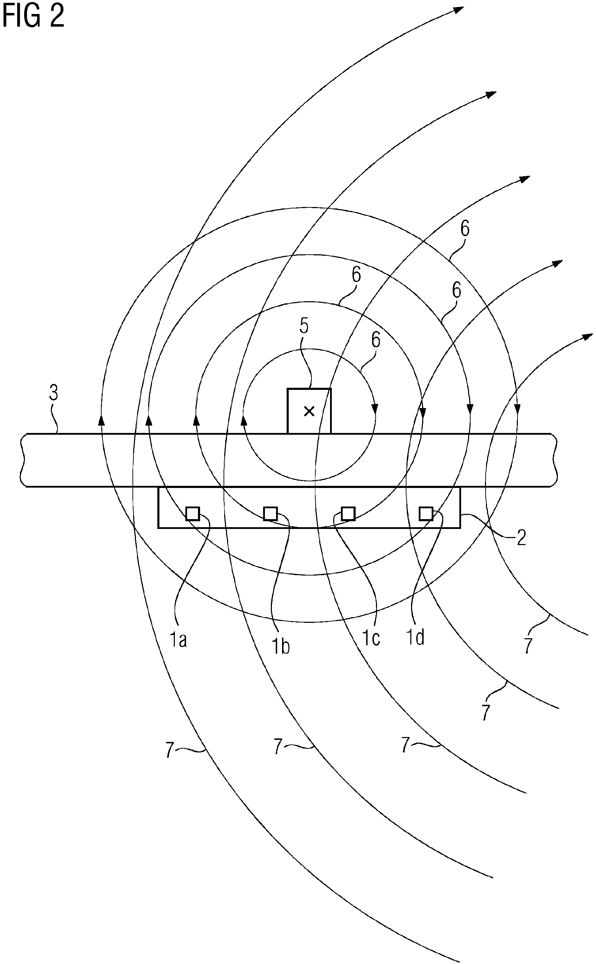

Fig. 2 stellt, basierend auf Fig. 1, den Fall dar, dass dem durch den Stromfluss erzeugten Magnetfeld 6 ein externes inhomogenes Magnetfeld 7 überlagert ist, welches z.B. das Erdmagnetfeld oder das Magnetfeld eines Permanentmagneten ist oder welches durch eine nicht dargestellte weitere stromdurchflossene Leitung hervorgerufen wird. Da die Inhomogenität des externen Magnetfelds 7, welches dem zu messenden Magnetfeld 6, d.h. dem Nutzsignal, überlagert ist, unbekannt ist, wie es in der Praxis der Fall ist, ist es unmöglich, die Stärke des zu messenden Magnetfeld 6 allein zu ermitteln. Eine korrekte Angabe der Stärke des in der elektrischen Leitung 5 fließenden elektrischen Stroms ist also nicht möglich.

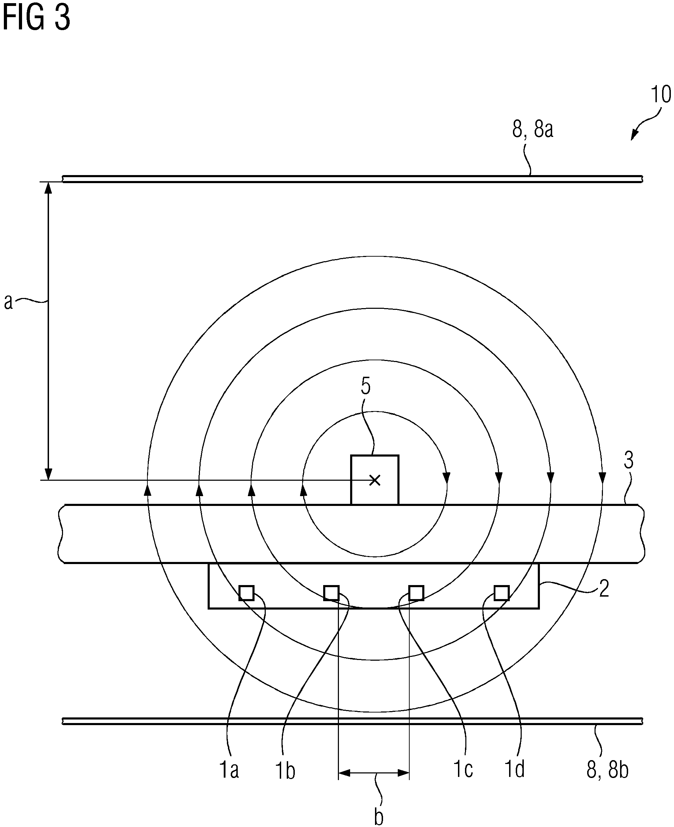

Fig. 3, basierend auf Fig. 1, stellt eine erfindungsgemäße Messanordnung dar. Aus Gründen der Vereinfachung wurde dabei auf die Darstellung von Signalleitung 14 und Recheneinheit 12 verzichtet. Gegenüber der in Fig. 1 dargestellten Anordnung weist die in Fig. 3 dargestellte erfindungsgemäße Messanordnung eine Filtereinheit 8 zum Homogenisieren von nicht durch den elektrischen Strom in der elektrischen Leitung 5 hervorgerufenen Magnetfeldern am Ort der Magnetfeldsensoren 1a, 1b, 1c, 1d auf. Die Filtereinheit 8 ist dabei ausgebildet durch zwei plattenförmige Filterelemente 8a und 8b, zwischen denen die elektrische Leitung 5 und die Magnetfeldsensoren 1a, 1b, 1c, 1d angeordnet sind. Dabei weist eines der Filterelemente 8a einen Abstand a von der elektrischen Leitung 5 auf. Zwei benachbarte Magnetfeldsensoren 1b, 1c weisen einen Abstand b voneinander auf, wobei der Abstand a größer als der Abstand b ist.

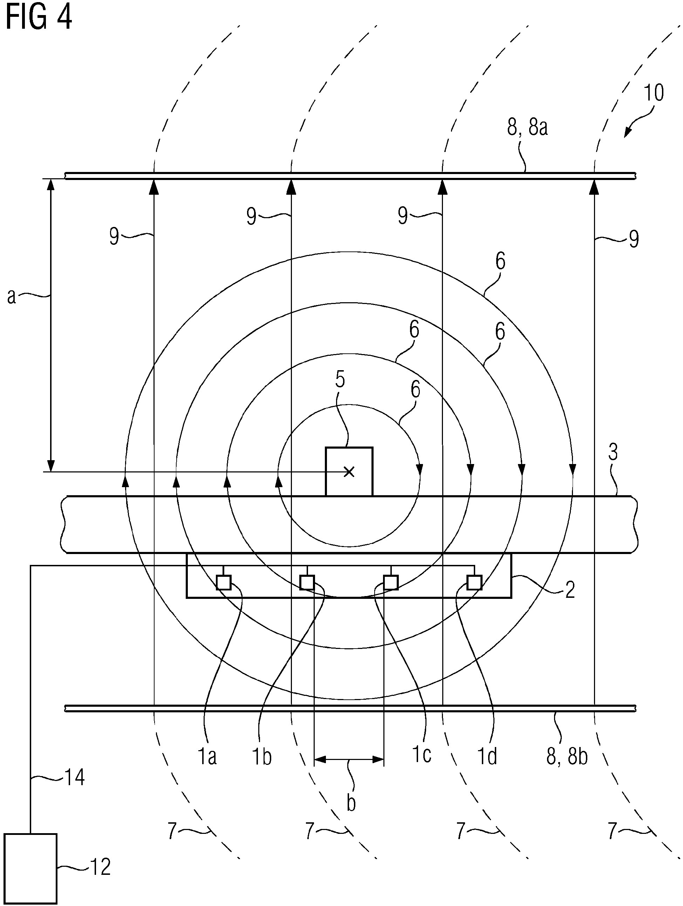

Fig. 4 stellt, basierend auf Fig. 3, den Fall dar, dass dem durch den Stromfluss erzeugten Magnetfeld 6 ein externes inhomogenes Magnetfeld 7 überlagert ist, welches z. B. das Erdmagnetfeld oder das Magnetfeld eines Permanentmagneten ist oder welches durch eine nicht dargestellte weitere stromdurchflossene Leitung hervorgerufen wird. Aufgrund der Filtereinheit weist das externe Magnetfeld 7 zwischen den beiden plattenförmigen Filterelementen 8 homogene, d. h. parallel verlaufende Magnetfeldlinien 9 gleicher Magnetfeldstärke auf, d.h. das externe Magnetfeld 7 ist zwischen den beiden plattenförmigen Filterelementen 8 homogenisiert.

Durch die zwischen den beiden plattenförmigen Filterelementen 8 erzielte Homogenisierung 9 des externen Magnetfelds, welches dem zu messenden Magnetfeld 6, d.h. dem Nutzsignal, überlagert ist, ist es nun möglich, mithilfe eines in der Recheneinheit 12 installierten Algorithmus' auf Basis der Signale der Magnetfeldsensoren 1a, 1b, 1c, 1d die Stärke des zu messenden Magnetfelds 6 allein zu ermitteln. Eine korrekte Angabe der Stärke des in der elektrischen Leitung 5 fließenden elektrischen Stroms ist also nun möglich, ohne dass diese durch das externe Magnetfeld verfälscht wird.

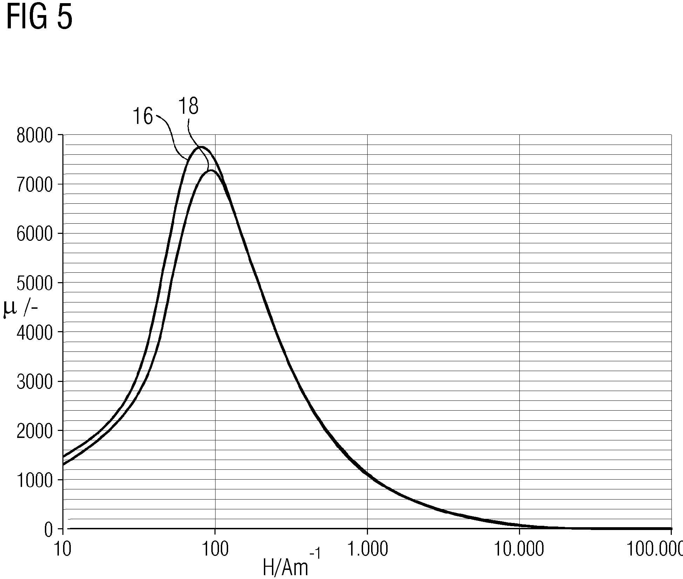

Fig. 5 zeigt in einem H-µᵣ-Diagramm mit der magnetischen Feldstärke H in der Einheit A/m entlang der x-Achse und der dimensionslosen Permeabilitätszahl µᵣ entlang der y-Achse die Verläufe 16, 18 von Permeabilitätszahlen µᵣ in Abhängigkeit der magnetischen Feldstärke H für zwei beispielhafte, für plattenförmige Filterelemente geeignete ferromagnetische Werkstoffe, nämlich den Verlauf 16 der Permeabilitätszahl µᵣ für das Elektroblech M 330-50 A sowie den Verlauf 18 der Permeabilitätszahl µᵣ für das Elektroblech M 530-50 A, jeweils mit einer Blechdicke von 0,50 mm. Der Verlauf der Permeabilitätszahl µᵣ ist für beide Materialien ungefähr gleich: bis zu einer magnetischen Feldstärke H im Bereich von 80 bzw. 100 A/m steigt die Permeabilitätszahl, erreicht bei 80 bzw. 100 A/m ein Maximum, und nimmt ab da stetig ab. Die beiden Materialien wurden gewählt, da sie bei einer magnetischen Feldstärke H von 1000 A/m immer noch eine Permeabilitätszahl µᵣ > 1000 haben.

Beide Elektroblech-Typen sind lediglich als Beispiele für geeignete Werkstoffe und nicht einschränkend zu verstehen; es sind auch andere ferromagnetische Werkstoffe zur Herstellung der Filterelemente einsetzbar.

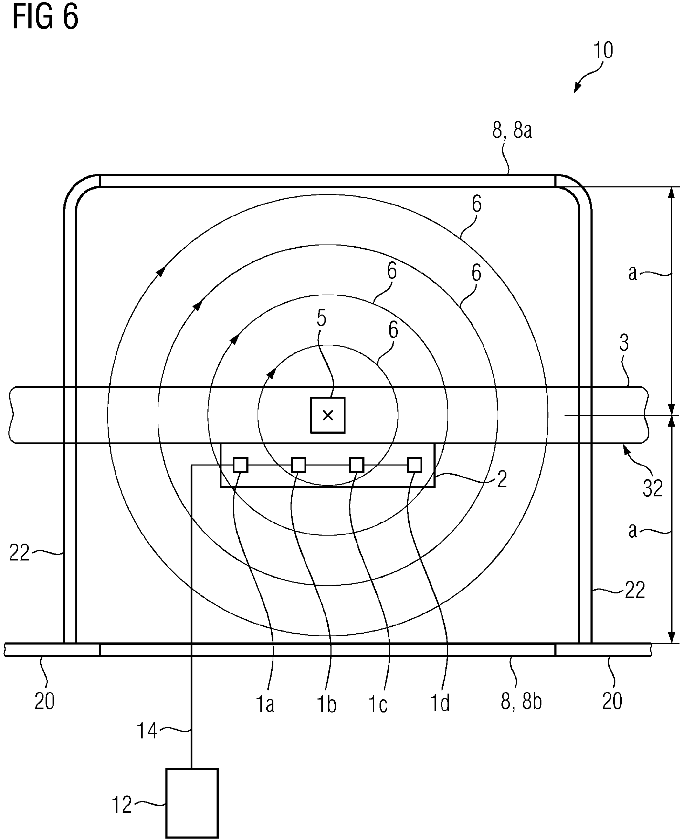

Fig. 6 ist ein Schnitt durch eine weitere Ausführung einer erfindungsgemäßen Messanordnung. Innenliegend in einer Leiterplatte 3 ist eine geradlinige elektrische Leitung 5 quadratischen Querschnitts angeordnet, entlang deren Längsachse, hervorgerufen durch eine an der elektrischen Leitung 5 anliegende Spannungsdifferenz, ein elektrischer Strom fließt. Die technische Stromrichtung, d. h. vom elektrischen Plus- zum Minuspol, ist dabei in die Zeichnungsebene hinein, so dass der Drehsinn der Feldlinien 6 des durch den Stromfluss erzeugten Magnetfelds gemäß der Korkenzieherregel im Uhrzeigersinn ist.

Auf einer Oberfläche 32 der Leiterplatte 3 ist ein Strommessmodul 2 angeordnet, welches vier in einer Reihe quer zur elektrischen Leitung 5 angeordnete Hallsensoren 1a bis 1d als Magnetfeldsensoren aufweist. Diese Hallsensoren 1a bis 1d erfassen die in dem Hallsensor auftretende Hallspannung U_{H}, welche proportional zur Feldstärke des Magnetfelds und somit proportional zum Leiterstrom ist, und senden die Spannungswerte über eine Signalleitung 14 zu einer Recheneinheit 12, wo aus den gesammelten Spannungswerten die Stärke des in der elektrischen Leitung 5 fließenden elektrischen Stroms berechnet wird.

Die Messanordnung 10 weist eine Filtereinheit 8 zum Homogenisieren von Magnetfeldern, welche nicht durch den elektrischen Strom in der elektrischen Leitung 5 hervorgerufen werden, am Ort der Magnetfeldsensoren 1a, 1b, 1c, 1d auf. Die Filtereinheit 8 umfasst zwei plattenförmige Filterelemente 8a und 8b, welche auf entgegengesetzten Seiten der elektrischen Leitung 5 und der Magnetfeldsensoren 1a, 1b, 1c, 1d angeordnet sind. Dabei wird ein erstes Filterelement 8a von einem ersten Stützelement 22, welches sich an der Leiterplatte 3 abstützt und an der Leiterplatte 3 befestigt ist, in einem Abstand a von der elektrische Leitung 5 in Position gehalten. Ein zweites Filterelement 8b wird von einem zweiten Stützelement 20, welches mit dem ersten Stützelement 22 verbunden ist, in einem Abstand a von der elektrische Leitung 5 in Position gehalten. Auf diese Weise sind die beiden Filterelemente 8a, 8b relativ zueinander und relativ zu der Leiterplatte 3, und somit auch in Bezug auf die elektrische Leitung 5 und das Strommessmodul 2, in einer festen, definierten Position angeordnet.

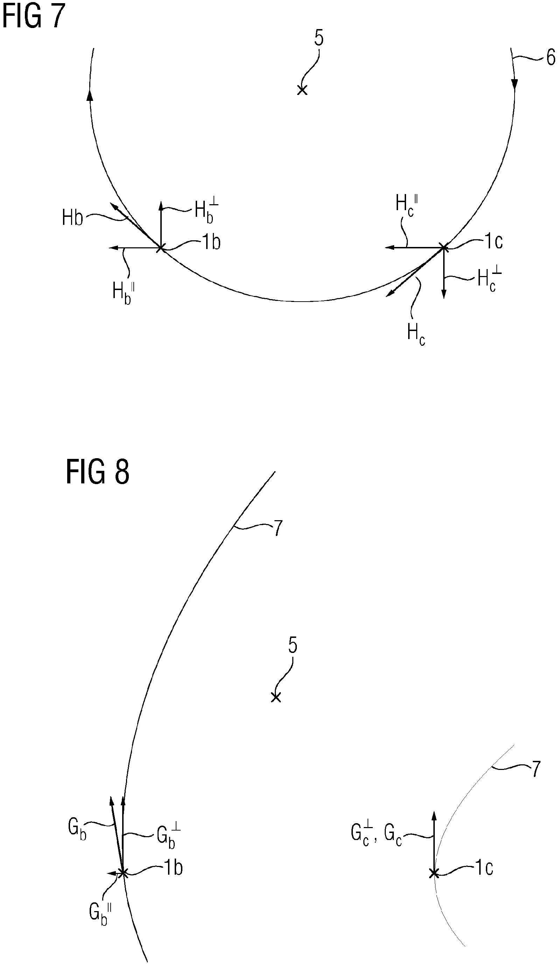

Fig. 7 bis 9 veranschaulichen den homogenisierenden Effekt der Filtereinheit unter dem Aspekt der in Teilkomponenten zerlegten Magnetfeldstärke.

Fig. 7 zeigt ein zu messendes Magnetfeld 6, welches durch eine stromdurchflossene Leitung 5 hervorgerufen wird. Die an den Positionen 1b und 1c angeordneten Hallsensoren sind so ausgerichtet, dass sie die mit H angegebene magnetische Feldstärke des Magnetfelds 6 nur in einer mit **⊥** angegebenen Quer-Richtung messen. Der an einer ersten Position 1b angeordnete Hallsensor misst von der an der ersten Position 1b vorliegenden magnetischen Feldstärke H_{b} nur die Quer-Komponente H_{b}^{⊥}, während die Parallel-Komponente H_{b}^{∥} nicht zum Signal des Hallsensors beiträgt. Der an einer zweiten Position 1c angeordnete Hallsensor misst von der an der zweiten Position 1c vorliegenden magnetischen Feldstärke H_{c} nur die Quer-Komponente H_{c}^{⊥}, während die Parallel-Komponente H_{c}^{∥} nicht zum Signal des Hallsensors beiträgt. Es ist zu beachten, dass aufgrund der symmetrischen Positionierung der beiden Hallsensoren in Bezug auf die stromführenden elektrischen Leitung 5 die erste Quer-Komponente H_{b}^{⊥} und die zweite Quer-Komponente H_{c}^{⊥} unterschiedliche Vorzeichen aufweisen.

Fig. 8 zeigt ein externes inhomogenes Magnetfeld 7, welches nicht durch die stromdurchflossene Leitung 5 hervorgerufen wird, sondern z.B. durch einen Permanentmagneten. Die an den Positionen 1b und 1c angeordneten Hallsensoren sind so ausgerichtet, dass sie die mit G angegebene magnetische Feldstärke des Magnetfelds 7 nur in einer mit **⊥** angegebenen Quer-Richtung messen. Der an einer ersten Position 1b angeordnete Hallsensor misst von der an der ersten Position 1b vorliegenden magnetischen Feldstärke G_{b} nur die Quer-Komponente G_{b}^{⊥}, während die Parallel-Komponente G_{b}^{∥} nicht zum Signal des Hallsensors beiträgt. Der an einer zweiten Position 1c angeordnete Hallsensor misst von der an der zweiten Position 1c vorliegenden magnetischen Feldstärke G_{c} nur die Quer-Komponente G_{c}^{⊥}, die aufgrund des Verlaufs des Magnetfelds 7 mit der magnetischen Feldstärke G_{c} identisch ist.

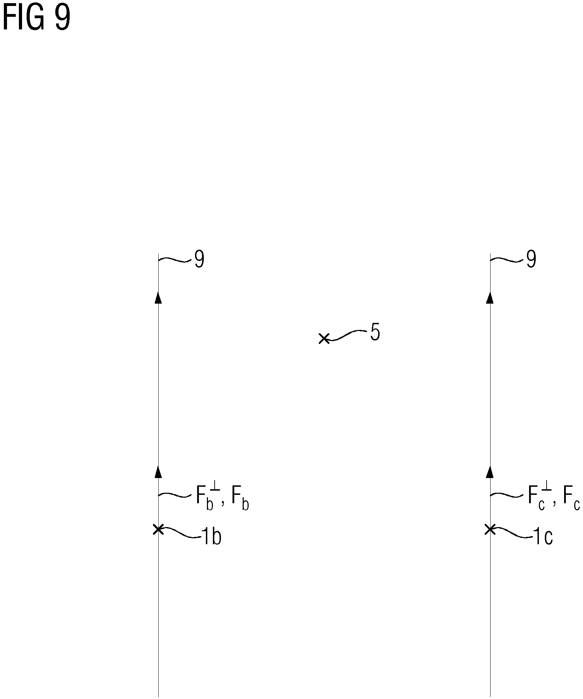

Fig. 9 zeigt ein externes homogenisiertes Magnetfeld 9, welches durch eine Filtereinheit aus dem in Fig. 8 dargestellten inhomogenen Magnetfeld 7 entstanden ist. Die an den Positionen 1b und 1c angeordneten Hallsensoren sind so ausgerichtet, dass sie die mit F angegebene magnetische Feldstärke des Magnetfelds 9 nur in einer mit ⊥ angegebenen Quer-Richtung messen. Der an einer ersten Position 1b angeordnete Hallsensor misst von der an der ersten Position 1b vorliegenden magnetischen Feldstärke F_{b} nur die Quer-Komponente F_{b}^{⊥}, die aufgrund des Verlaufs des Magnetfelds 9 mit der magnetischen Feldstärke F_{b} identisch ist. Der an einer zweiten Position 1c angeordnete Hallsensor misst von der an der zweiten Position 1c vorliegenden magnetischen Feldstärke F_{c} nur die Quer-Komponente F_{c}^{⊥}, die aufgrund des Verlaufs des Magnetfelds 9 mit der magnetischen Feldstärke F_{c} identisch ist.

Es ist zu beachten, dass aufgrund der Homogenität des Magnetfelds 9 die beiden Quer-Komponenten F_{b}^{⊥} und F_{c}^{⊥} gleich groß sind. Die aus einer Überlagerung der Quer-Komponenten der beiden Feldstärken H und F resultierenden Signale der Hallsensoren an den Positionen 1b, 1c können also einfach um die sich aus dem homogenisiertes Magnetfeld 9 ergebende konstante Komponente F_{b}^{⊥} = F_{c}^{⊥} bereinigt werden, um zu den Werten des tatsächlich zu messenden Magnetfelds 6 zu gelangen, das sich aus dem Stromfluss in der elektrischen Leitung 5 ergibt.

## Patentansprüche

1. Messanordnung (10) zum Erfassen eines in einer elektrischen Leitung (5) fließenden elektrischen Stroms, die Messanordnung (10) umfassend
- die elektrische Leitung (5),
- eine Strommesseinheit (2), die wenigstens zwei Magnetfeldsensoren (1a, 1b, 1c, 1d) zum Erfassen eines durch den elektrischen Strom hervorgerufenen Magnetfelds (6) aufweist, und
- eine Filtereinheit zum Homogenisieren von nicht durch den elektrischen Strom hervorgerufenen Magnetfeldern (7) am Ort der Magnetfeldsensoren (1a, 1b, 1c, 1d).

2. Messanordnung (10) nach Anspruch 1, wobei die Filtereinheit zwei flache Filterelemente (8) aufweist, zwischen denen die elektrische Leitung (5) und die Magnetfeldsensoren (1a, 1b, 1c, 1d) angeordnet sind.

3. Messanordnung (10) nach einem der vorhergehenden Ansprüche, wobei die Filterelemente (8) einen ferromagnetischen Werkstoff mit einer Permeabilitätszahl µr > 1 aufweisen.

4. Messanordnung (10) nach einem der vorhergehenden Ansprüche, wobei
- zumindest eines der Filterelemente (8) einen Abstand a von der elektrischen Leitung (5) aufweist,
- die Strommesseinheit (2) wenigstens zwei in einem Abstand b benachbart angeordnete Magnetfeldsensoren (1a, 1b, 1c, 1d) aufweist, und
- der Abstand a größer als oder gleich dem Abstand b ist.

5. Messanordnung (10) nach einem der vorhergehenden Ansprüche, wobei die Strommesseinheit (2) an einer Leiterplatte (3) angeordnet ist.

6. Messanordnung (10) nach einem der vorhergehenden Ansprüche, wobei die elektrische Leitung (5) an einer Leiterplatte (3) angeordnet ist.

7. Messanordnung (10) nach einem der vorhergehenden Ansprüche, wobei die Strommesseinheit (2) eine Recheneinheit umfasst, welche aus den Signalen der Magnetfeldsensoren (1a, 1b, 1c, 1d) den in der elektrischen Leitung (5) fließenden elektrischen Strom berechnet.

8. Verfahren zum Erfassen eines in einer elektrischen Leitung (5) fließenden elektrischen Stroms, wobei
- wenigstens zwei Magnetfeldsensoren (1a, 1b, 1c, 1d) im Bereich eines Magnetfelds (6), welches durch den elektrischen Strom hervorgerufen wird, angeordnet werden;
- nicht durch den elektrischen Strom hervorgerufene externe Magnetfelder (7) am Ort der Magnetfeldsensoren (1a, 1b, 1c, 1d) homogenisiert (9) werden;
- das durch den elektrischen Strom hervorgerufene Magnetfeld (6) und die diesem überlagerten homogenisierten Magnetfelder (9) mithilfe der Magnetfeldsensoren (1a, 1b, 1c, 1d) erfasst werden; und
- aus den Messsignalen der Magnetfeldsensoren (1a, 1b, 1c, 1d) die Stärke des elektrischen Stroms bestimmt wird.
